# EUROPÄISCHE PATENTANMELDUNG

(11) **EP 0 889 684 A2**
(43) Veröffentlichungstag der Anmeldung: **07.01.1999**
(21) Anmeldenummer: 98112143.7
(22) Anmeldetag: 30.06.1998
(51) Int. Cl.: H05K 7/14, H05K 3/36

(54) **Vorrichtung zur Verbindung von Leiterplatten getrennter Geräte**

(30) Priorität: 30.06.1997 DE 29711371 U
(71) Anmelder: SIEMENS AKTIENGESELLSCHAFT, 80333 München (DE)
(72) Erfinder: Gerlich, Walter, 86179 Augsburg (DE); Zell, Karl, 82343 Niederpöcking (DE); Siebold, Carsten, 82205 Gilching (DE)

(57) **Zusammenfassung**

Die Erfindung betrifft eine Vorrichtung zur elektrischen Verbindung zweier Leiterplatten von getrennten Geräten, welche einzelne Module innerhalb eines stapelbaren Modulsystems bilden.
Zur Erzielung einer einfach aufgebauten Verbindungsvorrichtung weisen die Leiterplatten jeweils Zentrier- oder Federleisten auf, in welche eine Adapterbaugruppe einsteckbar ist. Dabei besteht die Adapterbaugruppe aus zwei über eine Adapterbaugruppenleiterplatte fest miteinander verbundenen Messer- oder Federleisten, wobei die Adapterbaugruppe von fest miteinander verbundenen Schirmungsdeckeln umgeben ist. Im gesteckten Zustand sind die Adapterbaugruppen durch Gehäuseöffnungen in gegenüberliegenden Gehäuseteilen der übereinander gestapelten Geräte geführt, wobei die Außenseiten der Schirmungsdeckel die umgebenden Ränder der Gehäuseöffnungen kontaktieren.

## Beschreibung

Die vorliegende Erfindung betrifft eine Vorrichtung zur elektrischen Verbindung zweier Leiterplatten von getrennten Geräten, welche einzelne Module innerhalb eines stapelbaren Modulsystems bilden.

Die Datenkommunikation zwischen zwei Geräten ist je nach den auftretenden Taktfrequenzen nur mit großem schirmungstechnischen Aufwand realisierbar. Beim Übergang zwischen den jeweils für sich geschirmten Geräten wirken austretende Leitungen häufig als Antennen.

Zur Zeit wird die Datenübergabe zwischen Geräten mit externer Geräteverkabelung gelöst. Dabei treten Schirmungsprobleme auf, welche nur durch aufwendige und teuere geschirmte Kabel verbessert werden können. Daneben treten, bedingt durch Knickgefahr der nicht mechanisch geschützten Kabel, mechanische Probleme auf. Nachteilig ist auch die teuere Fertigung der geräteverbindenden Kabel aufgrund des hohen notwendigen Schirmungsgrad (Kabelschirm und Erdung). Ein weiterer Nachteil sind die Handlingsprobleme, bedingt durch das Nebeneinander einer Vielzahl von Kabeln, nämlich neben den Datenkabeln noch die notwendigen Strom- und Endgerätekabeln, die sich meist auf der Rückseite der Geräte befinden.

Aufgabe der vorliegenden Erfindung ist es daher, eine Vorrichtung der eingangs genannten Art anzugeben, welche eine einfache geschirmte Verbindung zwischen zwei Leiterplatten unterschiedlicher Geräte ermöglicht.

Diese Aufgabe wird erfindungsgemäß bei einer Vorrichtung der oben genannten Art dadurch gelöst, daß die Leiterplatten jeweils Zentrier- oder Federleisten aufweisen, in welche eine Adapterbaugruppe einsteckbar ist, daß die Adapterbaugruppe aus zwei über eine Adapterbaugruppenleiterplatte fest miteinander verbundene Messer- oder Federleisten besteht, wobei die Adapterbaugruppe von fest miteinander verbundenen Schirmungsdeckeln umgeben ist, daß im gesteckten Zustand die Adapterbaugruppen durch Gehäuseöffnungen in gegenüberliegenden Gehäuseteilen der übereinander gestapelten Geräte geführt sind, wobei die Außenseiten der Schirmungsdeckel die umgebenden Ränder der Gehäuseöffnungen kontaktieren.

Im Gegensatz zu dem immer noch hohen manuellen Aufwand bei der Kabelfertigung (Anschlagen des Kabelschirms, Konfektionierung, ...) ist die Fertigung der erfindungsgemäßen Vorrichtung kostengünstig. Die erfindungsgemäße Vorrichtung wird durch Einpressen der Zentrier- bzw. Federleisten in eine Leiterplatte und anschließendes Umhüllen mit zwei baugleichen Adapterbaugruppen-Schirmungsdeckeln realisiert.

Weitere Ausgestaltungen der erfindungsgemäßen Vorrichtung ergeben sich aus den Unteransprüchen sowie aus der Beschreibung zweier in der Zeichnung dargestellter Ausführungsbeispiele der vorliegenden Erfindung.

Es zeigen
FIG 1 in einer Explosionsdarstellung eine erfindungsgemäße Verbindung zwischen zwei in verschiedenen Geräten angeordnete Leiterplatten, wobei die beiden Leiterplatten in einer horizontalen Ebene der Geräte angeordnet sind, und
FIG 2 in einer Explosionsdarstellung eine erfindungsgemäße Verbindung zwischen zwei in verschiedenen Geräten angeordnete Leiterplatten, wobei die beiden Leiterplatten in einer vertikalen Ebene der Geräte angeordnet sind.

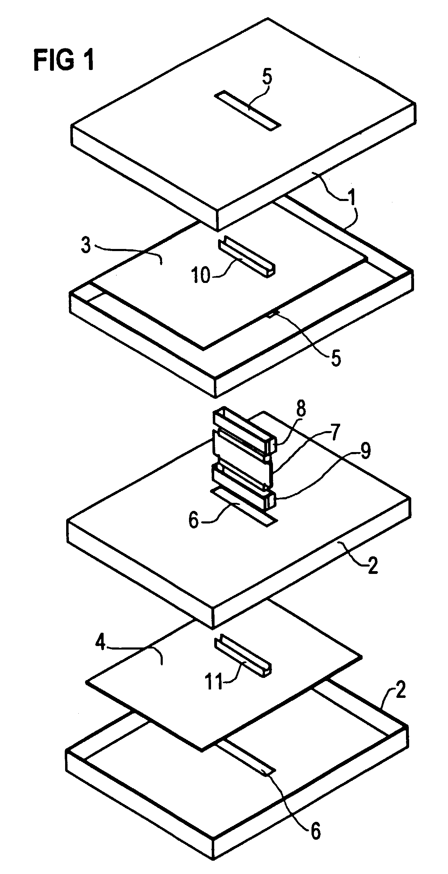

FIG 1 zeigt zwei unterschiedliche Geräte, die jeweils aus zwei Gehäuseteilen 1 bzw. 2 bestehen. In diesen beiden Geräten sind die direkt zu verbindenden Leiterplatten 3 und 4 jeweils in einer horizontal verlaufenden Ebene, bezogen auf die Gebrauchslage der beiden zu einem Modulsystem gehörenden Geräte, angeordnet. Die beiden Leiterplatten 3 und 4 verfügen über Zentrierleisten 10 bzw. 11 zur Aufnahme der die zwischen den Leiterplatten angeordneten und die Datenverbindung übernehmenden Adapterbaugruppe.

Die Adapterbaugruppe besteht im wesentlichen aus einer Adapterbaugruppenleiterplatte 7 mit an zwei gegenüberliegenden Randbereichen angebrachten Federleisten und zwei die Leiterplatte und die beiden Federleisten umgebenden Schirmungsdeckel 8 und 9, welche fest miteinander verbunden sind.

In den Gehäuseteilen 1 und 2 sind Gehäuseausschnitte 5 und 6 vorgesehen, durch welche die Adapterbaugruppen zur Verbindung der beiden Leiterplatten 3 und 4 hindurchgesteckt werden. Die Gehäuseausschnitte 5 und 6 werden z. B. durch das Entfernen oder Herausbrechen von Schirmfedern freigelegt. In diese Gehäuseausschnitte 5, 6 wird dann die Adapterbaugruppe eingesteckt und das nächste Gerät daraufgesetzt. Da die beiden Geräte einem Modulsystem angehören, sind sie in einem bestimmten Abstand parallel zueinander angeordnet, wobei die Länge der Adapterbaugruppe diesem Abstand angepaßt ist. Im gesteckten Zustand kontaktieren die äußeren Oberflächen der Adapterbaugruppen-Schirmungsdeckel 8, 9 die Kanten der Gehäuseausschnitte 5, 6 in den Gehäuseteilen 1 und 2, so daß eine vollständige Schirmung der Datenverbindung zwischen den Leiterplatten 3, 4 der beiden Geräte gegeben ist.

In Verbindung mit geeigneten Gerätefüßen ist nicht nur die elektrische und schirmungstechnische, sondern auch die mechanische Verbindung zwischen den Geräten gewährleistet (Stapeltechnik der Einzelmodule). Das System kann nachträglich leicht um entsprechende Module bzw. Geräte ergänzt werden. Durch seinen kompakten und mechanisch stabilen Aufbau kann die Adapterbaugruppe auch als tragendes Verbindungselement verwendet werden.

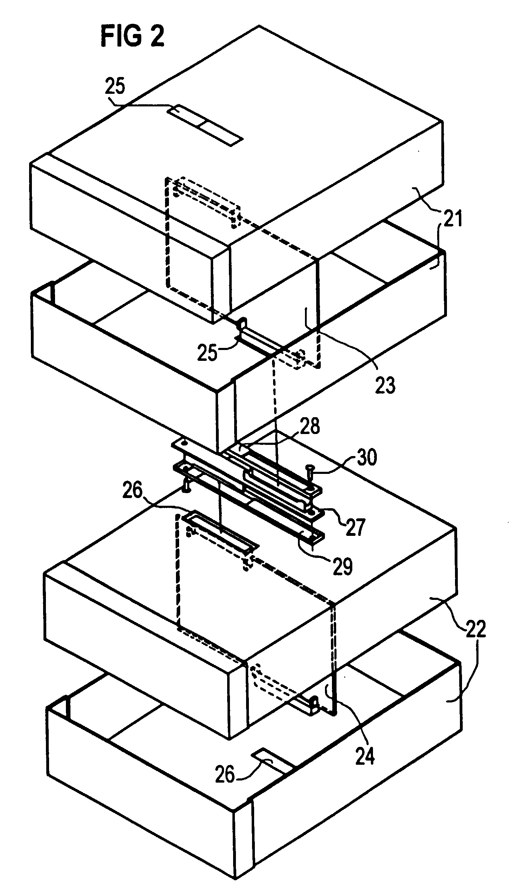

FIG 2 zeigt zwei weitere unterschiedliche Geräte, die jeweils aus zwei Gehäuseteilen 21 bzw. 22 bestehen. In diesen beiden Geräten sind die direkt zu verbindenden Leiterplatten 23 und 24 jeweils in einer vertikal verlaufenden Ebene, bezogen auf die Gebrauchslage der beiden zu einem Modulsystem gehörenden Geräte, angeordnet. Die beiden Leiterplatten 23 und 24 verfügen über Federleisten zur Aufnahme der die zwischen den Leiterplatten angeordneten und die Datenverbindung übernehmenden Adapterbaugruppe.

An dieser Stelle ist festzustellen, daß es im Belieben des Anwenders liegt, ob er den Leiterplatten Zentrierleisten und den Adapterbaugruppen Federleisten oder umgekehrt zuordnet.

Da bei einer vertikalen Anordnung der zu verbindenden Leiterplatten oft der gesamte Querschnitt des Gerätes durch die Leiterplatten ausgefüllt wird, wird in diesen Fällen ein platzsparender Aufbau der Adapterbaugruppe gefordert.

Die in FIG 2 gezeigte Adapterbaugruppe besteht im wesentlichen aus einer Adapterbaugruppenleiterplatte 27, welche sich senkrecht zu den Ebenen der zu verbindenden Leiterplatten 23, 24 erstreckt. Die beiden Zentrierleisten sind dabei gegeneinander versetzt auf der Unterseite und der Oberseite der Adapterbaugruppenleiterplatte 27 angebracht, und die die Leiterplatte und die beiden Messerleisten umgebenden Schirmungsdeckel 28 und 29, welche fest miteinander verbunden sind, weisen entsprechende Öffnungen für die Zentrierleisten auf.

In den Gehäuseteilen 21 und 22 sind Gehäuseausschnitte 25 und 26 vorgesehen, durch welche die Adapterbaugruppen zur Verbindung der beiden Leiterplatten 23 und 24 hindurchgesteckt werden. Die Gehäuseausschnitte 25 und 26 werden z. B. durch das Entfernen oder Herausbrechen von Schirmfedern freigelegt. In diese Gehäuseausschnitte 25, 26 wird dann die Adapterbaugruppe eingesteckt und das nächste Gerät daraufgesetzt. Da die beiden Geräte einem Modulsystem angehören, sind sie in einem bestimmten Abstand parallel zueinander angeordnet, wobei die Länge der Adapterbaugruppe diesem Abstand angepaßt ist. Im gesteckten Zustand kontaktieren die äußeren Oberflächen der Adapterbaugruppen-Schirmungsdeckel 28, 29 die Kanten der Gehäuseausschnitte 25, 26 in den Gehäuseteilen 21 und 22, so daß eine vollständige Schirmung der Datenverbindung zwischen den Leiterplatten 3, 4 der beiden Geräte gegeben ist.

Bezüglich der mechanischen Verbindung der zwei Geräte soll auf die Ausführungen im Zusammenhang mit FIG 1 hingewiesen werden.

Im Gegensatz zu dem immer noch hohen manuellen Aufwand bei der Kabelfertigung (Anschlagen des Kabelschirms, Konfektionierung, ...) ist die Fertigung der erfindungsgemäßen Vorrichtung kostengünstig. Die erfindungsgemäße Vorrichtung wird durch Einpressen der Zentrier- bzw. Federleisten in eine Leiterplatte und anschließendes Umhüllen mit zwei baugleichen Adapterbaugruppen-Schirmungsdeckeln realisiert.

Bei den zu verbindenden Leiterplatten kann es sich um Backplanes oder Motherboards eines Systems handeln.

## Patentansprüche

1. Vorrichtung zur elektrischen Verbindung zweier Leiterplatten von getrennten Geräten, welche einzelne Module innerhalb eines stapelbaren Modulsystems bilden,
dadurch gekennzeichnet,
daß die Leiterplatten (3, 4; 23, 24) jeweils Zentrier- oder Federleisten aufweisen, in welche eine Adapterbaugruppe einsteckbar ist,
daß die Adapterbaugruppe aus zwei über eine Adapterbaugruppenleiterplatte (7; 27) fest miteinander verbundenen Messer- oder Federleisten besteht, wobei die Adapterbaugruppe von fest miteinander verbundenen Schirmungsdeckeln (8, 9; 28, 29) umgeben ist,
daß die Adapterbaugruppen im gesteckten Zustand durch Gehäuseöffnungen (5, 6; 25, 26) in gegenüberliegenden Gehäuseteilen (1, 2; 21, 22) der übereinander gestapelten Geräte geführt sind, wobei die Außenseiten der Schirmungsdeckel (8, 9; 28, 29) die umgebenden Ränder der Gehäuseöffnungen (5, 6; 25, 26) kontaktieren.

2. Vorrichtung nach Anspruch 1,
dadurch gekennzeichnet,
daß bei horizontal angeordneten Leiterplatten (3, 4) die Adapterbaugruppenleiterplatte (7) senkrecht zu den Leiterplatten (3, 4) angeordnet ist und in einer Ebene mit den darauf befestigten Zentrier- bzw. Federleisten liegt.

3. Vorrichtung nach Anspruch 1,
dadurch gekennzeichnet,
daß bei vertikal angeordneten Leiterplatten (23, 24) die Adapterbaugruppenleiterplatte (27) senkrecht zu den Leiterplatten (3, 4) angeordnet ist und die darauf befestigten Zentrier- bzw. Federleisten in einer Ebene mit den Leiterplatten (23, 24) liegen.
